# EUROPEAN PATENT SPECIFICATION

(11) **EP 1 881 522 B1**
(45) Date of publication and mention of the grant of the patent: **11.05.2016**
(21) Application number: 07101402.1
(22) Date of filing: 30.01.2007
(51) Int. Cl.: H01L 21/20, H01L 21/02

(54) **Semiconductor substrate having low defects and method of manufacturing the same**
Halbleitersubstrat mit wenigen Fehlern und Herstellungsverfahren dafür
Substrat semi-conducteur présentant peu de défauts et son procédé de fabrication

(30) Priority: 21.07.2006 KR 20060068410
(43) Date of publication of application: 23.01.2008
(73) Proprietor: Samsung Electronics Co., Ltd., Suwon-si, Gyeonggi-do, 443-742 (KR)
(72) Inventor: Paek, Ho-sun, Gyeonggi-do (KR); Sung, Youn-joon, Gyeonggi-do (KR); Ha, Kyoung-ho, Gyeonggi-do (KR); Son, Joong-kon, Gyeonggi-do (KR); Lee, Sung-nam, Gyeonggi-do (KR)
(74) Representative: Greene, Simon Kenneth

(56) References cited:
- US-A- 6 051 849
- KREININ O ET AL: "Feasibility of rapid thermal MOVCD growth for fabrication of InP-based heterostructures" CONFERENCE PROCEEDINGS. 2001 INTERNATIONAL CONFERENCE ON INDIUM PHOSPHIDE AND RELATED MATERIALS. IPRM. NARA, JAPAN, MAY 14 - 18, 2001; [INTERNATIONAL CONFERENCE ON INDIUM PHOSPHIDE AND RELATED MATERIALS], NEW YORK, NY : IEEE, US, vol. CONF. 13, 14 May 2001 (2001-05-14), pages 401-404, XP010547060 ISBN: 978-0-7803-6700-5
- BEHRES A ET AL: "InP growth on ion-implanted InP substrate: A new method to achieve selective area MOVPE" JOURNAL OF CRYSTAL GROWTH, ELSEVIER, AMSTERDAM, NL, vol. 170, no. 1-4, 1 January 1997 (1997-01-01), pages 655-660, XP004087193 ISSN: 0022-0248
- SUN Y T ET AL: "Selective growth of InP on focused-ion-beam-modified GaAs surface by hydride vapor phase epitaxy" APPLIED PHYSICS LETTERS, AIP, AMERICAN INSTITUTE OF PHYSICS, MELVILLE, NY, US, vol. 79, no. 12, 17 September 2001 (2001-09-17), pages 1885-1887, XP012028936 ISSN: 0003-6951

## Description

### BACKGROUND OF THE INVENTION

The present invention relates to a semiconductor substrate and a method of manufacturing the same, and more particularly, to a low-defect semiconductor substrate having a low defect density and an excellent surface morphology property and a method of manufacturing the same.

GaN is a wide bandgap semiconductor having a direct transition type bandgap of 3.39eV and has been studied to be used in a variety of optoelectronic devices including blue light-emitting devices and protective thin films from the early of 1970. Since GaN has a continuous high solubility with an III-V-based nitride semiconductor such as InN or AIN, a trivalent nitride solid solution such as InₓGa₍₁₋ₓ₎N or GaₓAl₍₁₋ₓ₎N can be formed. And, since a bandgap is changed into a primary function for composition according to the composition of a ternary nitride, by adjusting the composition of the III-V-based nitride semiconductor, a light-emitting device or a light-receiving device including all visible regions from a red wavelength region to a ultraviolet wavelength region can be manufactured.

Since such a GaN thin film may be used in a variety of fields, the importance of study and developing of growth of a GaN thin film and a device using the same have been recognized long time ago and have proceeded. In these days, the study for heteroepitaxy in which a different kind of substrate such as sapphire (α-Al₂O₃) having large lattice mismatching and large thermal expansion coefficient mismatching with respect to GaN so as to grow a good GaN thin film and a GaN epitaxial layer is grown using a buffer layer such as AIN or GaN so as to alleviate mismatching of lattice parameter and thermal expansion coefficient has been briskly performed.

However, when GaN is grown on the different kind of substrate, a GaN or AIN buffer layer should be used at a low temperature of 500°C-600°C so as to alleviate lattice parameter and mismatching with respect to the substrate. As a result, an epitaxial growth process is complicated and the growth of various compounds such as InN or GaN required for manufacture of a light-emitting device may be not easily performed. In particular, due to a difference between a lattice parameter and a thermal expansion coefficient, a GaN thin film grown on a sapphire substrate includes many lattice defects, that is, a dislocation density of -10⁹/cm², the performance of the manufactured light-emitting device may be degraded. However, the defect density of a GaN-based optoelectronic device such as a light emitting diode (LED) or laser diode (LD) should be low so as to increase a life time thereof and so as to improve reliability thereof. In the case of a traditional substrate having a low defect density, GaN is grown thick using hydride vapor phase epitaxy (HVPE) growth and then is separated to be used as a GaN substrate. In this method, the GaN substrate does not have a sufficient low defect density yet and it is not easy to grow GaN sufficiently large with a size at which GaN is used as a substrate. Thus, as a method of manufacturing a low-defect GaN thin film, a method for reducing a defect density by performing lateral growth has been most spotlighted. As an example thereof, there are epitaxial lateral overgrowth (ELOG) and Pendeo-epitaxy. Regarding GaN growth using the ELOG and the Pendeo-epitaxy, U.S. Patent No. 6,051,849 or U.S. Patent No. 6,265,289 B1 may be referred to.

However, like ELOG, when a mask such as SiO₂ or SiNₓ is used, due to a difference in surface tension between a grown GaN thin film and the mask, crystals are tilted so that defects may be generated in a coalesced boundary of the GaN thin film. In this procedure, a groove may be formed on the surface of the GaN thin film and thus, a surface morphology property may be deteriorated. Due to the insertion of a different kind of material such as SiO₂ or SiNₓ, a strain may be nonuniformly distributed in the GaN thin film. In addition, since thermal conductivity of SiO₂ is lower than that of GaN, thermal reliability of a device implemented on a mask region may be degraded. Accordingly, in order to address these problems, the development of a new technology for manufacturing a low-defect semiconductor substrate having a low defect density and an excellent surface morphology property is needed.

US 6,051,849 teaches manufacture of a GaN layer by masking an underlying GaN layer with a mask and overgrowing a GaN layer through the openings of the mask and onto the mask to form an overgrown GaN layer.

The proceedings of the 2001 international conference on indium phosphide and related materials, Nara, JP, 14-18 May 2001, pages 401-404 discloses a selective growth process wherein amorphous implanted regions inhibit growth.

### SUMMARY OF THE INVENTION

The present invention provides a low-defect semiconductor substrate having a low defect density and an excellent surface morphology property and a method of manufacturing the same.

According to the present invention, there is provided a method of manufacturing a semiconductor substrate, according to claim 1.

The forming of the amorphous region and the crystalloid region on the surface of the first semiconductor layer may include: forming a mask layer of a posts pattern, a dot pattern or a stripe pattern for partly exposing a top surface of the first semiconductor layer, on the first semiconductor layer; forming an amorphous region caused by ion bombardment by applying ion bombardment to the exposed top surface of the first semiconductor layer according to the pattern of the mask layer; and exposing a crystalloid region caused by non-bombardment removing the mask layer.

A depth of 0.1-4 µm may be etched from the exposed top surface of the first semiconductor layer by applying ion bombardment and an amorphous region may be formed on the etched surface.

According to the present invention, a low-defect semiconductor substrate having a low defect density of about 10⁴ - 10⁷/cm² and having an excellent surface morphology property can be manufactured by a simple and easy process.

### BRIEF DESCRIPTION OF THE DRAWINGS

The above and other aspects of the present invention will become more apparent by describing in detail exemplary embodiments thereof with reference to the attached drawings in which:
FIG. 1 is a schematic cross-sectional view of a semiconductor substrate manufactured according to a comparative example;
FIGS. 2A through 2G illustrate a method of manufacturing a semiconductor substrate according to a comparative example;
FIGS. 3A through 3F illustrate a method of manufacturing a semiconductor substrate according to an embodiment of the present invention;
FIG. 4 is a schematic cross-sectional view of a light-emitting device; and
FIGS. 5A through 5C illustrate a method of manufacturing a light-emitting device.

### DETAILED DESCRIPTION OF THE INVENTION

The present invention will now be described more fully with reference to the accompanying drawings, in which exemplary embodiments of the invention are shown. In the drawings, the thicknesses of layers and regions are exaggerated for clarity.

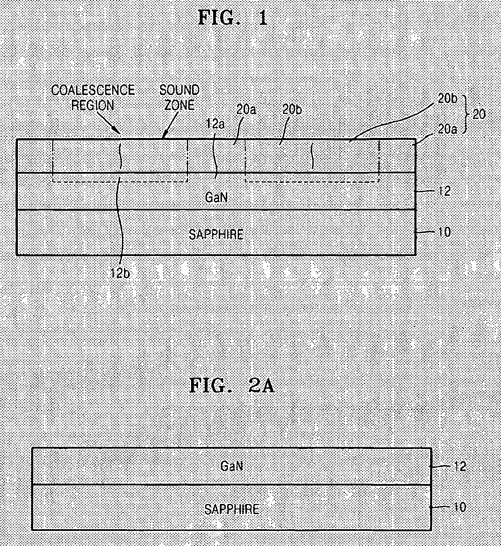

FIG. 1 is a schematic cross-sectional view of a semiconductor substrate manufactured according to a comparative example. Referring to FIG. 1, the semiconductor substrate 10 includes a first semiconductor layer 12 and a second semiconductor layer 20, which are sequentially formed on the growth substrate 10.

The first semiconductor layer 12 is formed of an II-VI-group semiconductor material or an III-V-group semiconductor material. An amorphous region 12b formed by an ion bombardment damage and a crystalloid (i.e. crystalline) region 12a formed by non-bombardment are formed on the first semiconductor layer 12. At this time, the amorphous region 12b and the crystalloid region 12a are repeatedly and alternately formed on the first semiconductor layer 12. And, the second semiconductor layer 20 includes a vertical growth region 20a crystally-grown vertically from the crystalloid region 12a and a lateral growth region 20b crystal-grown laterally from the vertical growth region 20a.

Since the growth substrate 10 is formed of one material selected from the group consisting of sapphire, 6H-SiC, MgAl₂O₃, Si(111), and ZnO, generally, the first semiconductor layer 12 formed on the different kind of growth substrate 10 is formed to have a thickness of 1-5µm and includes a defect density of 10⁸ - 10¹⁰/cm².

However, in the structure of the semiconductor substrate of FIG. 1, the second semiconductor layer 20 epitaxially grown on the first semiconductor layer 12 may include a defect density of 10⁴ - 10⁷/cm². In detail, the crystalloid region 12a is vertically/laterally crystally-grown by metal organic chemical vapor deposition (MOCVD) using the amorphous region 12b as a mask for suppressing crystal growth and using the crystalloid region 12a as a seed for crystal growth, thereby forming the second semiconductor layer 20 having a lower defect density that that of the first semiconductor layer 12 on the first semiconductor layer 12. Here, the vertical growth region 20a includes a defect density of 10⁸ - 10¹⁰/cm² and the lateral growth region 20b includes a defect density of 10⁴ - 10⁷/cm².

In this case, the second semiconductor layer 20 may be formed of a material having the same lattice parameter and thermal expansion coefficient as those of a material used in forming the first semiconductor layer 12 or a material having a sufficiently small lattice parameter and thermal expansion coefficient as those of the material used in forming the first semiconductor layer 12 so that epitaxial growth can be easily performed. For example, the second semiconductor layer 20 may be formed of an II-VI-group semiconductor material or an III-V-group semiconductor material, which is the same as the material used in forming the first semiconductor layer 12. Here, the II-VI-group semiconductor material may be ZnO and the III-V-group semiconductor material may be one material selected from the group consisting of GaN, GaAs, and InP.

The width of the amorphous region 12b may be 2-30µm, which is a value obtained by considering the efficiency of lateral growth using the seed. The second semiconductor layer 2 may be effectively epitaxially-grown within a width range of 2-30 µm in a short time. A thickness of the amorphous region 12b may be 0.1-500nm. The amorphous region 12b should be thick enough to function as a mask for suppressing crystal growth and thus does not need to be equal to or greater than 500 nm. For the same reason, when the thickness of the amorphous region 12b is too small, that is, is equal to or less 0.1 nm, the amorphous region 12b does not function as the mask, the thickness of the amorphous region 12b should be equal to or greater than 0.1 nm.

The width of the crystalloid region 12a may be 1-20 µm, which is a value obtained by considering a size suitable for serving as the seed for crystal growth. Here, since the amorphous region 12b and the crystalloid region 12a are repeatedly and alternately formed on the first semiconductor layer 12, there is a correlation between the disposal and arrangement thereof but the shape or pattern thereof is not limited to. For example, the crystalloid region 12a may be formed in a dot pattern or in a small circle pattern. In addition, the amorphous region 12b and the crystalloid region 12a may be formed in a stripe pattern. The stripe pattern may be formed in a <1-100> direction so that the lateral growth can be performed in a <11-20> direction. As a result of the lateral growth, a coalescence region of the second semiconductor layer 20 is formed on the amorphous region 12b and a surface morphology property is shown in the coalescence region. A sound zone shown in FIG. 1 denotes a low-defect density region caused by the lateral growth.

Since a mask made of a different material such as SiO₂ or SiNₓ like in conventional GaN growth using epitaxial lateral overgrowth (ELOG) or Pendeo-epitaxy is not used but the amorphous region 12b formed by an ion bombardment damage is used as a mask, a strain may be uniformly distributed in the GaN thin film, that is, in the second semiconductor layer 20. In addition, since the thermal conductivity of the amorphous GaN region 12b is higher than that of SiO₂, the thermal reliability of an optoelectronic device, such as a light emitting diode (LED) or a laser diode (LD), implemented on the amorphous region 12b can be improved.

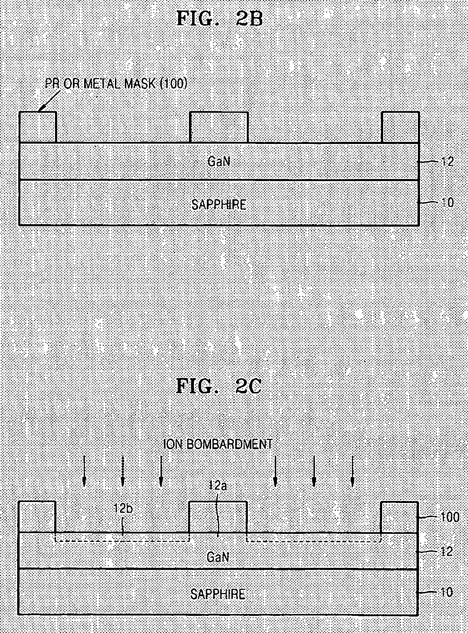

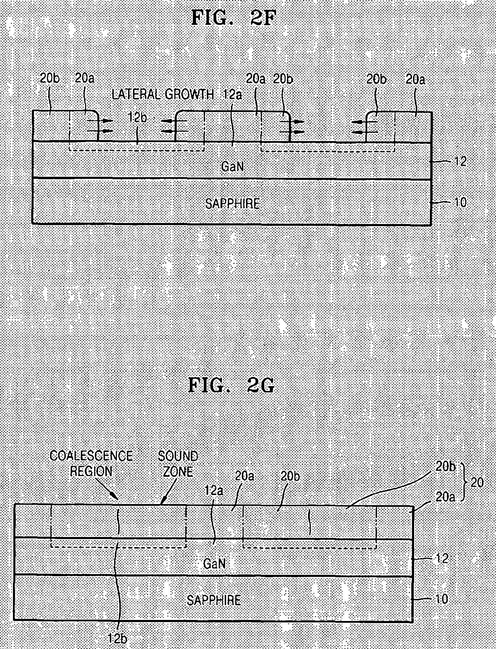

FIGS. 2A through 2G illustrate a method of manufacturing a semiconductor substrate according to the comparative example. Here, each material layer may be formed by halide or hydride vapor phase epitaxy (HVPE), metal organic chemical vapor deposition (MOCVD), molecular beam epitaxy (MBE), plasma enhanced chemical vapor deposition (PECVD), vapor deposition such as sputtering or evaporation.

Referring to FIG. 2A, a growth substrate 10 suitable for lattice matching for the growth of an II-VI-group semiconductor layer or an III-V-group semiconductor layer is prepared. For example, the growth substrate 10 may be formed of one material selected from the group consisting of sapphire, 6H-SiC, MgAl₂O₃, Si(111), and ZnO. Next, a first semiconductor layer 12 is crystally grown using an II-VI-group semiconductor material or an III-V-group semiconductor material on the growth substrate 10. Here, the II-VI-group semiconductor material may be ZnO, and the III-V-group semiconductor material may be one material selected from the group consisting of GaN, GaAs, and InP. The thickness of the first semiconductor layer 12 may be 1-5µm. And, the first semiconductor layer 12 grown on a different kind of the growth substrate 10 in this way may include a defect density of 10⁸-10¹⁰/cm².

Referring to FIGS. 2B through 2D, the amorphous region 12b caused by a bombardment damage and the crystalloid region 12a caused by non-bombardment are repeatedly and alternately formed on the first semiconductor layer 12 by partly applying ion bombardment to the surface of the first semiconductor layer 12.

Specifically, first, referring to FIG. 2B, a mask layer 100 in a posts pattern, a dot pattern or a stripe pattern for partly exposing the top surface of the first semiconductor layer 12, is formed on the first semiconductor layer 12. The mask layer 100 may be formed of a photoresist or metal.

Referring to 2C, the amorphous region 12b caused by a bombardment damage is formed by applying ion bombardment to the exposed top surface of the first semiconductor layer 12 according to the pattern of the mask layer 100. An ion source for the ion bombardment may include at least one atom ion selected from the group consisting of B, P, As, Sb, BF₂, In, Ar, N, and Zn. And, the ion bombardment may be performed under a vacuum pressure of less than 1.33 mPa (10⁻⁵ torr). In detail, the ion source may be supplied by a radio frequency (RF)-ion source, a discharge type, a surface ionization source or a hot electron.

The thickness of the amorphous region 12b may be 0.1-500nm and the width thereof may be 2-30 µm. The amorphous region 12b should be thick enough to function as a mask for suppressing crystal growth and thus does not need to be equal to or greater than 500 nm. For the same reason, when the thickness of the amorphous region 12b is too small, that is, is equal to or less 0.1 nm, the amorphous region 12b does not function as the mask, the thickness of the amorphous region 12b should be equal to or greater than 0.1 nm.

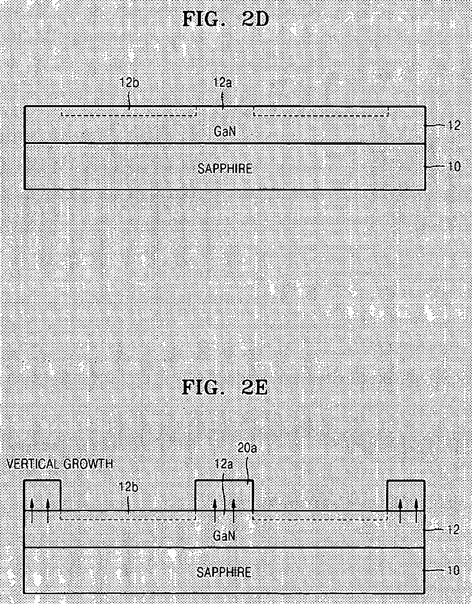

Referring to FIG. 2D, the crystalloid region 12a caused by non-bombardment is exposed by removing the mask layer 100. The width of the crystalloid region 12a may be 1-20 µm. The width may be very suitable for a seed for crystal growth.

Referring to FIGS. 2E through 2G, the crystalloid region 12a is vertically/laterally crystally-grown by metal organic chemical vapor deposition (MOCVD) using the amorphous region 12b as a mask for suppressing crystal growth and using the crystalloid region 12a as a seed for crystal growth, thereby forming a second semiconductor layer 20 having a lower defect density that that of the first semiconductor layer 12 on the first semiconductor layer 12. The second semiconductor layer 20 includes a vertical growth region 20a crystal-grown vertically from the amorphous region 12b and a lateral growth region 20b crystal-grown laterally from the vertical growth region 20a. The second semiconductor layer 20 includes a defect density of 10⁴ - 10⁷/cm². In detail, the vertical growth region 20a includes a defect density of 10⁸ - 10¹⁰/cm² and the lateral growth region 20b includes a defect density of 10⁴ - 10⁷/cm². In this case, the second semiconductor layer 20 may be formed of a material having the same lattice parameter and thermal expansion coefficient as those of a material used in forming the first semiconductor layer 12 or a material having a sufficiently small lattice parameter and thermal expansion coefficient as those of the material used in forming the first semiconductor layer 12 so that epitaxial growth can be easily performed. For example, the second semiconductor layer 20 may be formed of an II-VI-group semiconductor material or on III-V-group semiconductor material, which is the same as the material used in forming the first semiconductor layer 12.

In the current example, the amorphous region 12b and the crystalloid region 12a may be formed in a stripe pattern along a <1-100> direction. As a result, the lateral growth of the amorphous region 12a may be performed in a <11-20> direction. In particular, GaN shows an excellent growth property in the <11-20> direction.

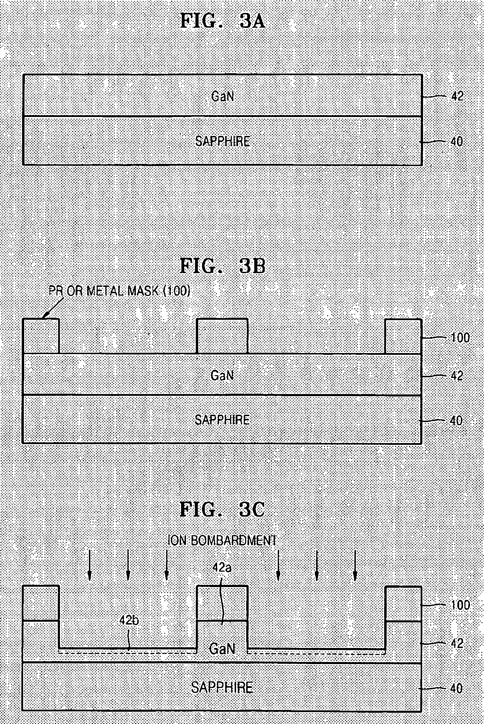

FIGS. 3A through 3F illustrate a method of manufacturing a semiconductor substrate according to an embodiment of the present invention. Most processes of the current embodiment are the same as those of the example of FIGS. 2A through 2G. Thus, a description of the repeated processes will be omitted and the current embodiment will be described in association with a difference in processes.

Referring to FIGS. 3A and 3B, a first semiconductor layer 42 is crystally grown using an II-VI-group semiconductor material or an III-V-group semiconductor material on a growth substrate 40. Then, a mask layer 100 in a posts pattern, a dot pattern or a stripe pattern for partly exposing the top surface of the first semiconductor layer 42, is formed on the first semiconductor layer 42. These processes are the same as those of the embodiment of FIGS. 2A and 2B.

Referring to FIG. 3C, an amorphous region 42b caused by a bombardment damage is formed by applying ion bombardment to the exposed top surface of the first semiconductor layer 42 according to the pattern of the mask layer 100. In this case, there is a difference between the current embodiment and the previous comparative example of FIGS. 2A through 2G in that a depth of 0.1-4 µm is etched from the exposed top surface of the first semiconductor layer 42 by applying the ion bombardment and the amorphous region 42b is formed on the etched surface.

Like in the previous comparative example of FIGS. 2A through 2G, an ion source for the ion bombardment may include at least one atom ion selected from the group consisting of B, P, As, Sb, BF₂, In, Ar, N, and Zn. And the ion bombardment may be performed under a vacuum pressure of less than 1.33 mPa (10⁻⁵ torr). In detail, the ion source may be supplied by a radio frequency (RF)-ion source, a discharge type, a surface ionization source or a hot electron. In addition, the thickness of the amorphous region 42b may be 0.1-500 nm and the width thereof may be 2-30 µm.

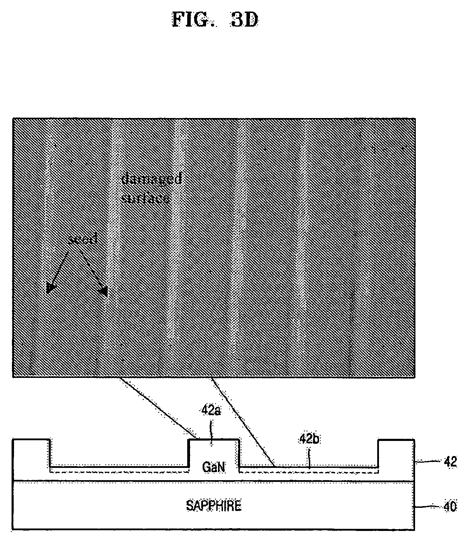

Referring to FIG. 3D, a crystalloid region 42a caused by non-bombardment is exposed by removing the mask layer 100. As a result of etching, the crystalloid region 42a has a three-dimensional (3D) shape, that is, a protruded shape. This protruded shape may be more advantageous to crystal growth to a lateral side. The width of the crystalloid 42a may be 1-20 µm. A scanning electron microscopy (SEM) photo showing the surface of the first semiconductor layer 42 patterned by the etching is together shown in FIG. 3D.

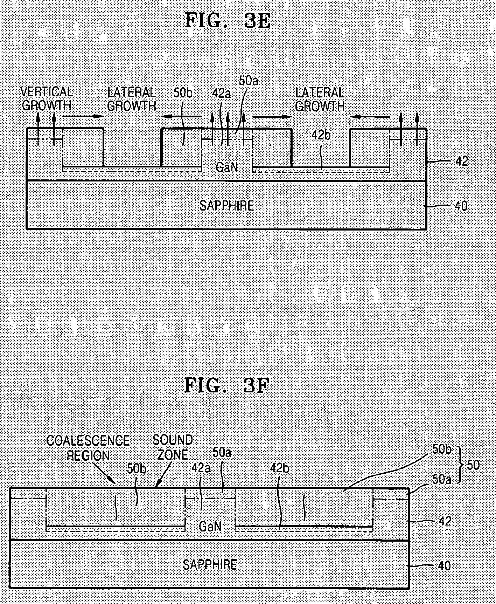

Referring to FIGS. 3E and 3F, the crystalloid region 42a is vertically/laterally crystally-grown by metal organic chemical vapor deposition (MOCVD) using the amorphous region 42b as a mask for suppressing crystal growth and using the crystalloid region 42a as a seed for crystal growth, thereby forming a second semiconductor layer 50 having a lower defect density that that of the first semiconductor layer 42 on the first semiconductor layer 42. The second semiconductor layer 50 includes a vertical growth region 50a crystal-grown vertically from the crystalloid region 42a and a lateral growth region 50b crystal-grown laterally from the crystalloid region 42a. The second semiconductor layer 50 includes a defect density of 10⁴ - 10⁷/cm². In detail, the vertical growth region 50a includes a defect density of 10⁸ - 10¹⁰/cm² and the lateral growth region 50b includes a defect density of 10⁴ - 10⁷/cm².

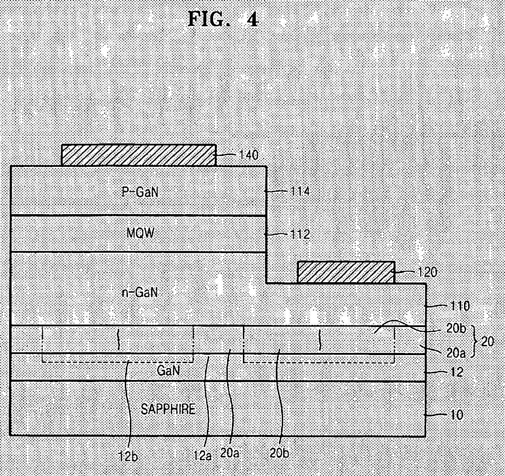

FIG. 4 is a schematic cross-sectional view of a semiconductor light-emitting device. Referring to FIG. 4, the semiconductor light-emitting device includes a semiconductor substrate manufactured according to FIGS. 2A through 2G and a semiconductor chip formed on the semiconductor substrate.

The semiconductor substrate includes a first semiconductor layer 12 and a second semiconductor layer 20, which are sequentially formed on a growth substrate 10. The first semiconductor layer 12 is formed of an II-VI-group semiconductor material or an III-V-group semiconductor material. The first semiconductor layer 12 includes an amorphous region 12b formed by an ion bombardment damage and a crystalloid region 12a formed by non-bombardment. In this case, the amorphous region 12b and the crystalloid region 12a are repeatedly and alternately formed on the first semiconductor layer 12. The second semiconductor layer 20 includes a vertical growth region 20a crystally-grown vertically from the crystalloid region 12a and a lateral growth region 20b crystally-grown laterally from the vertical growth region 20a. Here, the structure of the semiconductor substrate manufactured according to FIGS. 2A through 2G and a method of manufacturing the same have been already described. Thus, a repeated description of the semiconductor substrate will be omitted and the structure of the semiconductor chip will be described.

The semiconductor chip includes an n-electrode 120, a p-electrode 140, an n-type semiconductor layer 110 disposed therebetween, an active layer 112, and a p-type semiconductor layer 114. In detail, the n-type semiconductor layer 110, the active layer 112, and the p-type semiconductor layer 114 are sequentially stacked on the second semiconductor layer 20, and a portion of the uppermost surface of the p-type semiconductor layer 114 is etched to a predetermined depth of the n-type semiconductor layer 110 so that the n-type semiconductor layer 110 is exposed. And, the n-electrode 120 is formed on the exposed surface of the n-type semiconductor layer 110, and the p-electrode 140 is formed on the uppermost surface of the p-type semiconductor layer 114. In a GaN-based semiconductor light-emitting device having the above structure, if a predetermined voltage is applied between the n-electrode 120 and the p-electrode 140, electrons and holes are injecting into the active layer 112 from the n-type semiconductor layer 110 and the p-type semiconductor layer 114, respectively, and the electrons and the holes coalesce within the active layer 112 so that light can be emitted from the active layer 112.

Since the second semiconductor layer 20 has a low defect density of about 10⁴-10⁷/cm² and an excellent surface morphology property, the optical output property of the light-emitting device implemented on the second semiconductor layer is improved and the thermal reliability of the light-emitting device is improved so that the life time of the light-emitting device can be increased.

The n-type semiconductor layer 110 may be formed of an AllnGaN-based III-V-group nitride semiconductor material, for example, may be an n-GaN layer. The active layer 112 may be a GaN-based III-V-group nitride semiconductor layer which is InₓAl_{y}Ga_{1-x-y}N(0≤x≤1, 0≤y≤1 and 0≤x+y≤1), for example, may be an InGaN layer or an AlGaN layer. Here, the active layer 112 may be formed of one structure of a multi-quantum well (hereinafter, referred to as 'MQW') and a single quantum well. For example, the active layer 112 is most preferably formed of a GaN/InGaN/GaN MQW or GaN/AlGaN/GaN MQW structure. And, the p-type semiconductor layer 114 may be a p-GaN-based III-V-group nitride semiconductor layer, for example, may be a p-GaN layer or a p-GaN/AlGaN layer.

The n-electrode 120 and the p-electrode 140 may be formed of a conductive material, for example, metal such as Au, Al or Ag or transparent conductive oxide. The transparent conductive oxide may be one oxide selected from the group consisting of indium tin oxide (ITO), zinc-doped indium tin oxide (ZITO), zinc indium oxide (ZIO), gallium indium oxide (GIO), zinc tin oxide (ZTO), fluorine-doped tin oxide (FTO), aluminum-doped zinc oxide (AZO), gallium-doped zinc oxide (GZO), In₄Sn₃O₁₂, and Zn₁₋ₓMgₓO(Zinc Magnesium Oxide, 0≤x≤1). As a specific example thereof, there is Zn₂In₂O₅, GaInO₃, ZnSnO₃, F-doped SnO₂, Al-doped ZnO, Ga-doped ZnO, MgO or ZnO.

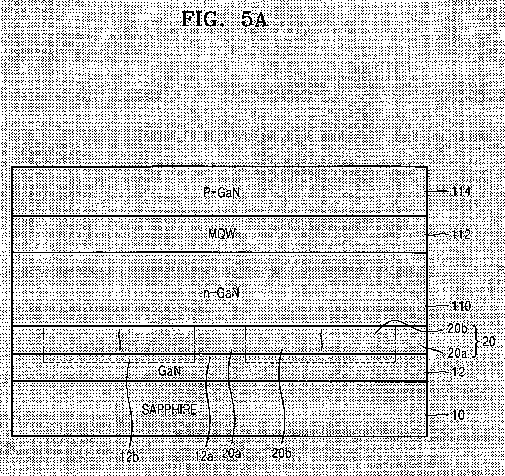

FIGS. 5A through 5C illustrate a method of manufacturing a semiconductor light-emitting device. The method of manufacturing a semiconductor substrate illustrated in FIGS. 2A through 2G has been already described. Thus, a repeated description of the semiconductor substrate will be omitted and a method of manufacturing a semiconductor chip will be described. Here, each material layer may be formed by halide or hydride vapor phase epitaxy (HVPE), metal organic chemical vapor deposition (MOCVD), molecular beam epitaxy (MBE), plasma enhanced chemical vapor deposition (PECVD), vapor deposition such as sputtering or evaporation. These methods are well-known and thus, a detailed description thereof will be omitted.

Referring to FIG. 5A, after a semiconductor substrate is manufactured according to FIGS. 2A through 2G, a n-type semiconductor layer 110, an active layer 112, and a p-type semiconductor layer 114 are sequentially formed on the semiconductor substrate.

Specifically, after a growth substrate 10 suitable for lattice matching for the growth of an II-VI-group semiconductor layer or an III-V-group semiconductor layer is prepared, a first semiconductor layer 12 is crystally grown using an II-VI-group semiconductor material or an III-V-group semiconductor material on the growth substrate 10. Then, an amorphous region 12b caused by a bombardment damage and a crystalloid region 12a caused by non-bombardment are repeatedly and alternately formed on the first semiconductor layer 12 by partly applying ion bombardment to the surface of the first semiconductor layer 12. Next, the crystalloid region 12a is vertically/laterally crystally-grown by metal organic chemical vapor deposition (MOCVD) using the amorphous region 12b as a mask for suppressing crystal growth and using the crystalloid region 12a as a seed for crystal growth, thereby forming a second semiconductor layer 20 having a lower defect density that that of the first semiconductor layer 12 on the first semiconductor layer 12.

Next, the n-type semiconductor layer 110, the active layer 112, and the p-type semiconductor layer 114 are sequentially formed on the second semiconductor layer 20. The n-type semiconductor layer 110 may be formed of an AllnGaN-based III-V-group nitride semiconductor material, for example, may be an n-GaN layer. The active layer 112 may be a GaN-based III-V-group nitride semiconductor layer which is InₓAl_{y}Ga_{1-x-y}N(0≤x≤1, 0≤y≤1 and 0≤x+y≤1), for example, may be an InGaN layer or an AlGaN layer. Here, the active layer 112 may be formed of one structure of a multi-quantum well (hereinafter, referred to as 'MQW') and a single quantum well. The structure of the active layer 112 does not limit the technical scope of the present invention. For example, the active layer 112 is most preferably formed of a GaN/InGaN/GaN MQW or GaN/AlGaN/GaN MQW structure. And, the p-type semiconductor layer 114 may be a p-GaN-based III-V-group nitride semiconductor layer, for example, may be a p-GaN layer or a p-GaN/AlGaN layer.

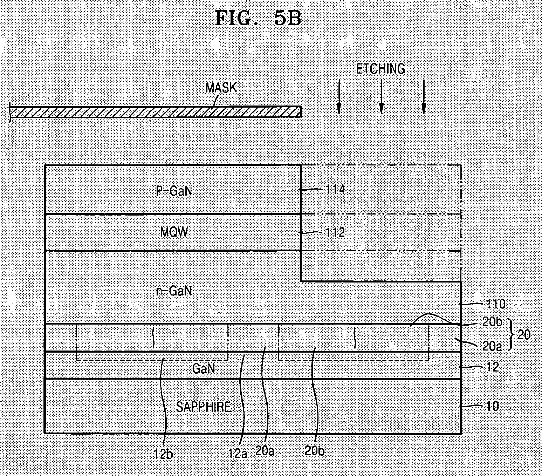

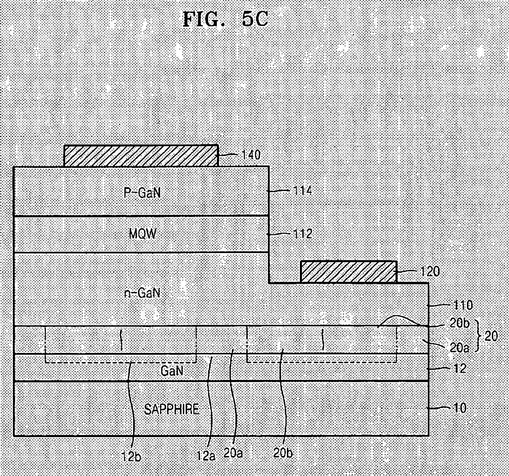

Referring to FIGS. 5B and 5C, a predetermined region of a top surface of the p-type semiconductor layer 114 is etched to a predetermined depth of the n-type semiconductor layer 110, thereby forming an etched surface on the n-type semiconductor layer 110. Then, an n-electrode 50 and a p-electrode 60 are formed using a conductive material, for example, metal such as Au, Al or Ag or a transparent conductive oxide, on the etched surface of the n-type semiconductor layer 110 and on the p-type semiconductor layer 114.

According to the present invention, a low-defect semiconductor substrate having a low defect density of about 10⁴ - 10⁷/cm² and having an excellent surface morphology property can be manufactured by a simple and easy process. The semiconductor substrate may be used as a substrate for manufacturing optoelectronic devices such as GaN-based light emitting diodes (LED) or laser diodes (LD) such that the life time and reliability of the optoelectronic devices are improved.

## Claims

1. A method of manufacturing a semiconductor substrate, the method comprising:
preparing a growth substrate (40) suitable for lattice matching for growing an III-V-group semiconductor layer;
crystally-growing a first semiconductor layer (42) using an III-V-group semiconductor material on the growth substrate;
forming a mask layer of a posts pattern, a dot pattern or a stripe pattern for partly exposing a top surface of the first semiconductor layer, on the first semiconductor layer;
etching the exposed top surface of the first semiconductor layer to a depth by applying ion bombardment to form an amorphous region (42b) on the etched surface;
exposing a crystalloid region (42a) on a surface of the first semiconductor layer caused by non-bombardment by removing the mask layer; and
forming a second semiconductor layer (50) having a lower defect density than a defect density of the first semiconductor layer on the first semiconductor layer using the amorphous region as a mask and using the crystalloid region as a seed, by growing a vertical growth region (50a) vertically on the crystalloid region and growing a lateral growth region (50b) laterally from the crystalloid region over the amorphous region.

2. The method of claim 1, wherein the second semiconductor layer (50) is formed by metal organic chemical vapor deposition (MOCVD).

3. The method of claim 1, wherein the mask layer is formed of photoresist or metal.

4. The method of claim 1 or 3, wherein the stripe pattern is formed in a <1-100> direction.

5. The method of claim 1, 3 or 4, wherein the etching of the exposed top surface of the first semiconductor layer comprises etching the exposed top surface of the first semiconductor layer to the depth of 0.1-4 µm.

6. The method of any of claims 1 to 5, wherein the growth substrate (40) is formed of one material selected from the group consisting of sapphire, 6H-SiC, MgAl₂O₃, Si(111), and ZnO.

7. The method of any of claims 1 to 6, wherein the III-V-group semiconductor material includes at least one material selected from the group consisting of GaN, GaAs, and InP.

8. The method of any preceding claim, wherein an ion source for ion bombardment includes at least one atom ion selected from the group consisting of B, P, As, Sb, BF₂, In, Ar, N, and Zn.

9. The method any preceding claim, wherein the ion bombardment is performed under a vacuum pressure of less than 1.33 mPa (10⁻⁵ torr).

10. The method of any preceding claim, wherein an ion source for ion bombardment is supplied by a radio frequency (RF)-ion source, a discharge type, a surface ionization source or a hot electron.

11. The method of any preceding claim, wherein a thickness of the first semiconductor layer (42) is 1-5 µm.

12. The method of any of claims 1 to 11 wherein a width of the amorphous region (42b) is 2-30 µm.

13. The method of any of claims 1 to 12, wherein a thickness of the amorphous region (42b) is 0.1 - 500 nm.

14. The method of any of claims 1 to 13, wherein a width of the crystalloid region (42a) is 1-20 µm.

15. The method of any of claims 1 to 14, wherein the amorphous region (42b) and the crystalloid region (42a) are formed in a stripe pattern.

16. The method of claim 15, wherein the stripe pattern is formed in a <1-100> direction.

17. The method of any of claims 1 to 16, wherein the second semiconductor layer (50) is formed by growing the crystalloid region in a <11-20> direction.

18. The method of any of claims 1 to 17, wherein the first semiconductor layer (40) includes a defect density of 10⁸-10¹⁰/cm².

19. The method of any of claims 1 to 18, wherein the second semiconductor layer (50) includes a defect density of 10⁴-10⁷/cm².

20. The method of claim 7 or any of claims 8 to 19 when dependent on claim 7, wherein the first semiconductor layer (42) and the second semiconductor layer (50) are formed of a nitride semiconductor.

21. A method of manufacturing a semiconductor light-emitting device, the method comprising:
preparing a substrate using a method according to any preceding claim; and
sequentially forming an n-type semiconductor layer (110), an active layer (112), and a p-type semiconductor layer (114) on the second semiconductor layer.

## Patentansprüche

1. Verfahren zur Herstellung eines Halbleitersubstrats, wobei das Verfahren Folgendes umfasst:
Herstellen eines Wachstumssubstrats (40), das für die Gitteranpassung zum Züchten einer Halbleiterschicht der III-V-Gruppe geeignet ist;
Kristallzüchten einer ersten Halbleiterschicht (42) unter Verwendung eines Halbleitermaterials der III-V-Gruppe an dem Wachstumssubstrat;
Formen einer Maskierungsschicht aus einem pfostenförmigen Muster, einem Punktmuster oder einem Streifenmuster auf der ersten Halbleiterschicht zum teilweisen Exponieren einer oberen Fläche der ersten Halbleiterschicht;
Ätzen der exponierten oberen Fläche der ersten Halbleiterschicht auf eine Tiefe durch das Anwenden von Ionenbeschuss, um auf der geätzten Fläche einen amorphen Bereich (42b) zu formen;
Exponieren eines kristalloiden Bereichs (42a) auf einer Fläche der ersten Halbleiterschicht, verursacht durch Nichtbeschuss durch das Entfernen der Maskierungsschicht; und
Formen einer zweiten Halbleiterschicht (50), die eine niedrigere Defektdichte aufweist als eine Defektdichte der ersten Halbleiterschicht auf der ersten Halbleiterschicht, unter Verwendung des amorphen Bereichs als eine Maskierung und unter Verwendung des kristalloiden Bereichs als ein Samen, indem ein vertikaler Wachstumsbereich (50a) vertikal auf dem kristalloiden Bereich gezüchtet wird und ein lateraler Wachstumsbereich (50b) lateral von dem kristalloiden Bereich über den amorphen Bereich gezüchtet wird.

2. Verfahren nach Anspruch 1, wobei die zweite Halbleiterschicht (50) durch eine metallorganische chemische Gasphasenabscheidung (MOCVD) geformt wird.

3. Verfahren nach Anspruch 1, wobei die Maskierungsschicht aus einem Fotolack oder einem Metall geformt wird.

4. Verfahren nach Anspruch 1 oder 3, wobei das Streifenmuster in einer <1-100>-Richtung geformt wird.

5. Verfahren nach Anspruch 1, 3 oder 4, wobei das Ätzen der exponierten oberen Fläche der ersten Halbleiterschicht das Ätzen der exponierten oberen Fläche der ersten Halbleiterschicht auf die Tiefe von 0,1-4 µm umfasst.

6. Verfahren nach einem der Ansprüche 1 bis 5, wobei das Wachstumssubstrat (40) aus einem Material geformt wird, das aus der Gruppe ausgewählt wird, die sich aus Saphir, 6H-SiC, MgAl₂O₃, Si(111) und ZnO zusammensetzt.

7. Verfahren nach einem der Ansprüche 1 bis 6, wobei das Halbleitermaterial der III-V-Gruppe mindestens ein Material umfasst, das aus der Gruppe ausgewählt wird, die sich aus GaN, GaAs und InP zusammensetzt.

8. Verfahren nach einem vorhergehenden Anspruch, wobei eine Ionenquelle für den Ionenbeschuss mindestens ein Atomion umfasst, das aus der Gruppe ausgewählt wird, die sich aus B, P, As, Sb, BF₂, In, Ar, N und Zn zusammensetzt.

9. Verfahren nach einem vorhergehenden Anspruch, wobei der Ionenbeschuss bei einem Vakuumdruck von weniger als 1,33 mPa (10⁻⁵ torr) durchgeführt wird.

10. Verfahren nach einem vorhergehenden Anspruch, wobei eine Ionenquelle für den Ionenbeschuss über eine Hochfrequenz-(RF)-Ionenquelle, eine Entladung, eine Oberflächenionisationsquelle oder ein Heißelektron bereitgestellt wird.

11. Verfahren nach einem vorhergehenden Anspruch, wobei eine Dicke der ersten Halbleiterschicht (42) 1-5 µm entspricht.

12. Verfahren nach einem der Ansprüche 1 bis 11, wobei eine Breite des amorphen Bereichs (42b) 2-30 µm entspricht.

13. Verfahren nach einem der Ansprüche 1 bis 12, wobei eine Dicke des amorphen Bereichs (42b) 0,1-500 nm entspricht.

14. Verfahren nach einem der Ansprüche 1 bis 13, wobei eine Breite des kristalloiden Bereichs (42a) 1-20 µm entspricht.

15. Verfahren nach einem der Ansprüche 1 bis 14, wobei der amorphe Bereich (42b) und der kristalloide Bereich (42a) in einem Streifenmuster geformt sind.

16. Verfahren nach Anspruch 15, wobei das Streifenmuster in einer <1-100>-Richtung geformt wird.

17. Verfahren nach einem der Ansprüche 1 bis 16, wobei die zweite Halbleiterschicht (50) durch das Züchten des kristalloiden Bereichs in einer <11-20>-Richtung geformt wird.

18. Verfahren nach einem der Ansprüche 1 bis 17, wobei die erste Halbleiterschicht (40) eine Defektdichte von 10⁸-10¹⁰ /cm² umfasst.

19. Verfahren nach einem der Ansprüche 1 bis 18, wobei die zweite Halbleiterschicht (50) eine Defektdichte von 10⁴-10⁷ /cm² umfasst.

20. Verfahren nach Anspruch 7 oder einem der Ansprüche 8 bis 19, wenn in Abhängigkeit von Anspruch 7, wobei die erste Halbleiterschicht (42) und die zweite Halbleiterschicht (50) aus einem Nitridhalbleiter geformt werden.

21. Verfahren zur Herstellung einer Halbleiterleuchtvorrichtung, wobei das Verfahren Folgendes umfasst:
Herstellen eines Substrats unter Verwendung eines Verfahrens nach einem vorhergehenden Anspruch; und
sequentielles Formen einer n-Typ-Halbleiterschicht (110), einer aktiven Schicht (112) und einer p-Typ-Halbleiterschicht (114) auf der zweiten Halbleiterschicht.

## Revendications

1. Procédé de fabrication d'un substrat semi-conducteur, ledit procédé comprenant :
la préparation d'un substrat de croissance (40) conçu pour la correspondance du réseau afin de faire croître une couche de semi-conducteur du groupe III à V ;
la croissance par cristaux d'une première couche semi-conductrice (42) au moyen d'un matériau semi-conducteur du groupe III à V sur le substrat de croissance ;
la formation d'une couche de masque en forme de poteau ou à motif à points ou à motif à rayures pour exposer partiellement la surface supérieure de la première couche semi-conductrice, sur la première couche semi-conductrice ;
la gravure de la surface supérieure exposée de la première couche semi-conductrice jusqu'à une certaine profondeur par application d'un bombardement ionique pour former une région amorphe (42b) sur la surface gravée ;
l'exposition d'une région cristalloïde (42a) à la surface de la première couche semi-conductrice engendrée par non-bombardement en enlevant la couche de masque ; et
la formation d'une seconde couche semi-conductrice (50) présentant une plus faible densité de défauts que la densité de défauts de la première couche semi-conductrice sur la première couche semi-conductrice en utilisant la région amorphe comme masque et en utilisant la région cristalloïde comme germe, en faisant croître une région de croissance verticale (50a) à la verticale sur la région cristalloïde et en faisant croître une région de croissance latérale (50b) latéralement par rapport à la région cristalloïde au-dessus de la région amorphe.

2. Procédé selon la revendication 1, ladite seconde couche semi-conductrice (50) étant formée par dépôt chimique en phase vapeur à partir de composés organométalliques (MOVCD).

3. Procédé selon la revendication 1, ladite couche de masque étant formée de photorésist ou de métal.

4. Procédé selon la revendication 1 ou 3, ledit motif à rayures étant formé dans une direction de <1 à 100>.

5. Procédé selon la revendication 1, 3 ou 4, ladite gravure de la surface supérieure exposée de la première couche semi-conductrice comprenant la gravure de la surface supérieure exposée de la première couche semi-conductrice jusqu'à une épaisseur de 0,1 à 4 µm.

6. Procédé selon l'une quelconque des revendications 1 à 5, ledit substrat de croissance (40) étant formé d'un matériau choisi dans le groupe constitué par le saphir, 6H-SiC, MgAl₂O₃, Si(111) et ZnO.

7. Procédé selon l'une quelconque des revendications 1 à 6, ledit matériau semi-conducteur du groupe III à V incluant au moins un matériau choisi dans le groupe constitué par GaN, GaAs et InP.

8. Procédé selon l'une quelconque des revendications précédentes, la source d'ions pour ledit bombardement ionique comprenant au moins un atome ion choisi dans le groupe constitué par B, P, As, Sb, BF₂, In, Ar, N et Zn.

9. Procédé selon l'une quelconque des revendications précédentes, ledit bombardement ionique étant effectué sous une pression de vide inférieure à 1,33 mPa (10⁻⁵ torr).

10. Procédé selon l'une quelconque des revendications précédentes, ladite source d'ions pour le bombardement ionique étant fournie par une source d'ions à haute fréquence (RF), une source de type à décharge, une source à ionisation de surface ou des électrons chauds.

11. Procédé selon l'une quelconque des revendications précédentes, l'épaisseur de ladite première couche semi-conductrice (42) étant de 1 à 5 µm.

12. Procédé selon l'une quelconque des revendications 1 à 11, le diamètre de ladite région amorphe (42b) faisant de 2 à 30 µm

13. Procédé selon l'une quelconque des revendications 1 à 12, l'épaisseur de ladite région amorphe (42b) faisant de 0,1 à 500 nm.

14. Procédé selon l'une quelconque des revendications 1 à 13, le diamètre de ladite région cristalloïde (42a) faisant de 1 à 20 µm.

15. Procédé selon l'une quelconque des revendications 1 à 14, ladite région amorphe (42b) et ladite région cristalloïde (42a) étant formées en un motif à rayures.

16. Procédé selon la revendication 15, ledit motif à rayures étant formé dans une direction de <1 à 100>.

17. Procédé selon l'une quelconque des revendications 1 à 16, ladite seconde couche semi-conductrice (50) étant formée en faisant croître la région cristalloïde dans une direction de <11 à 20>.

18. Procédé selon l'une quelconque des revendications 1 à 17, ladite première couche semi-conductrice (40) comportant une densité de défauts de 10⁸ à 10¹⁰/cm².

19. Procédé selon l'une quelconque des revendications 1 à 18, ladite seconde couche semi-conductrice (50) comportant une densité de défauts de 10⁴ à 10⁷/cm².

20. Procédé selon la revendication 7 ou selon l'une quelconque des revendications 8 à 19 lorsqu'elles dépendent de la revendication 7, ladite première couche semi-conductrice (42) et ladite seconde couche semi-conductrice (50) étant formées sur un semi-conducteur en nitrure.

21. Procédé de fabrication d'un dispositif semi-conducteur émetteur de lumière, ledit procédé comprenant :
la préparation d'un substrat en utilisant un procédé selon l'une quelconque des revendications précédentes ;
et
la formation séquentielle d'une couche semi-conductrice de type n (110), d'une couche active (112) et d'une couche semi-conductrice de type p (114) sur la seconde couche semi-conductrice.
